Europäisches Patentamt

European Patent Office

Office européen des brevets

(11) Veröffentlichungsnummer: **0 348 726**
**A2**

## (12) EUROPÄISCHE PATENTANMELDUNG

(21) Anmeldenummer: 89110681.7

(22) Anmeldetag: 13.06.89

(51) Int. Cl.⁴: **G08C 17/00**

(30) Priorität: 25.06.88 DE 3821572

(43) Veröffentlichungstag der Anmeldung:
03.01.90 Patentblatt 90/01

(84) Benannte Vertragsstaaten:
**AT BE DE ES FR GB IT LU NL**

(71) Anmelder: **NOKIA UNTERHALTUNGSELEKTRONIK (DEUTSCHLAND) GMBH**
**Östliche Karl-Friedrich-Strasse 132**
**D-7530 Pforzheim(DE)**

(72) Erfinder: **Apitz, Siegfried**
**L.-Windthorst-Strasse 24**
**D-7530 Pforzheim(DE)**

(54) **Fernbedienungsanordnung.**

(57) Zur Fernbedienung mehrerer gleichartig fernbedienbarer elektrischer Geräte (2, 3) mit einem einzigen Fernbedienungsgeber (1) ist im Fernbedienungsempfänger 14) eine Adresse (A1, A2) eines Adressenspeichers (16) wirksam geschaltet, die den Fernbedienungsempfänger (14) kennzeichnet und bewirkt, daß der Fernbedienungsempfänger nur solche Fernbedienungssignale (12) empfängt und auswertet, deren Adressenteil (AT) die im Fernbedienungsempfänger wirksame Adresse enthält. Der zu dieser Gerätegruppe zugehörige Fernbedienungsgeber (1) enthält auf dem Bedienfeld (4) zusätzlich ein Auswahlelement (8), mit dem in einem Adressengeber (11) eine zugehörige Adresse (A1, A2) ausgewählt und im Übertragungssignalgenerator (7) dem Adressenteil (AT) des drahtlos übertragenen Fernbedienungssignales (12) zugeführt wird.

FIG.1

## Fernbedienungsanordnung

Die Erfindung betrifft eine Fernbedienungsanordnung nach dem Oberbegriff des Anspruches 1.

Bei der immer größer werdenden Anzahl fernbedienbarer Geräte in einem Haushalt und der unterschiedlichen Übertragungssysteme für die Übertragung der Fernbedienungssignale wird auch die Anzahl der in einem Haushalt befindlichen Fernbedienungsgeber so groß, daß die Zuordnung der Fernbedienungsgeber zu einzelnen fernbedienbaren Geräten vom Benutzer nicht mehr überschaubar ist. Deshalb besteht das Bestreben, mehrere fernbedienbare elektrische Geräte zu einer Gerätegruppe zusammenzufassen, die von einem einzigen Fernbedienungsgeber erfaßt und eingestellt werden kann. So ist es beispielsweise aus der Zeitschrift Funkschau 1985, Heft 18, Seiten 54 bis 58 bekannt, Fernsehgeräte und Videorecorder eines Herstellers mit einer einzigen Fernbedienung zu betätigen. Bei einer anderen, aus der Funkschau 1982, Heft 10, Seiten 63 bis 66 bekannten Rundfunkempfangs- und -wiedergabeanlage sind fünf fernbedienbare elektrische Geräte zu einer Gerätegruppe zusammengeschlossen. Nur eines der Geräte dieser Gerätegruppe enthält einen Fernbedienungsempfänger und dient als Steuerzentrale dieser Gerätegruppe. Die übrigen Geräte der bekannten Gerätegruppe sind über Fernsteuerleitungen an das den Fernbedienungsempfänger enthaltende Gerät der Gerätegruppe angeschlossen. Der zugehörige Fernbedienungsgeber enthält auf seinem Bedienungsfeld für jedes fernbedienbare Gerät der Gerätegruppe eine optisch abgegrenzte Tastengruppe zur Fernbedienung der Funktionen des zugehörigen fernbedienbaren Gerätes. Durch diese Maßnahme ist zwar die Zahl der Fernbedienungsgeber zur Fernbedienung der in der Gerätegruppe enthaltenen fernbedienbaren elektrischen Geräte wesentlich eingeschränkt. Andererseits wird jedoch durch die Vielzahl der Bedienungselemente auf dem der Gerätegruppe zugeordneten Fernbedienungsgeber so groß, daß einem auf diesem Fachgebiet technisch nicht vorgebildeten Benutzer eines derartigen Fernbedienungsgebers die Benutzung dieses Fernbedienungsgebers sehr erschwert ist.

Andererseits tritt es immer näufiger auf, daß in einem Haushalt ein fernbedienbares elektrisches Gerät mehrfach vorhanden ist und der Benutzer beabsichtigt, diese gleichartigen fernbedienbaren elektrischen Geräte zeitlich überlappend fernzubedienen. Wird beispielsweise in einem Haushalt ein Videorecorder augenblicklich zur Wiedergabe einer Videokassette verwendet und gleichzeitig ein zweiter Videorecorder desselben Herstellers zur Aufnahme einer Videosendung verwendet, besteht die Gefahr, daß das eine Gerät durch die Bedienung des Fernbedienungsgebers des anderen Gerätes beeinflußt und in falsche Funktionen eingestellt wird.

Der Erfindung liegt die Aufgabe zugrunde, bei einer Verwendung von fernbedienbaren elektrischen Geräten, die über die gleichen Fernbedienungssignale fernbedienbar sind, zu gewährleisten, daß nur das ausgewählte fernbedienbare Gerät einer Gruppe gleichartig fernbedienbarer Geräte beinflußt wird. Diese Aufgabe wird nach der Erfindung durch die im kennzeichnenden Teil des Anspruches 1 angegebenen Merkmale gelöst.

Durch die Maßnahmen nach der Erfindung wird erreicht, daß für eine Gruppe gleichartig fernbedienbarer elektrischer Geräte nicht nur ein einziger Ferbedienungsgeber erforderlich ist, sondern daß auch die Anzahl der Bedienungselemente auf dem Bedienungsfeld des Fernbedienungsgebers nur unwesentlich, nämlich nur um die Anzahl der Bedienungselemente zur Auswahl der fernbedienbaren elektrischen Geräte erhöht wird.

Die Unteransprüche kennzeichnen vorteilhafte Ausgestaltungen der Erfindung. Sind im Adressensignalgeber des Fernbedienungsgebers einerseits und in den Fernbedienungsempfängern der über gleiche Fernbedienungssignale fernbedienbaren Geräte andererseits die gleichen auswählbaren Adressen eingespeichert, dann sind an den Fernbedienungsempfängern nur einfache oder überhaupt keine mechanischen Vorrichtungen zum Einstellen einer dem Fernbedienungsempfänger kennzeichnenden Adresse erforderlich und am Fernbedienungsgeber kann die Einstelleinrichtung zur Auswahl des einzustellenden elektrischen Gerätes ebenfalls einfach ausgestaltet werden.

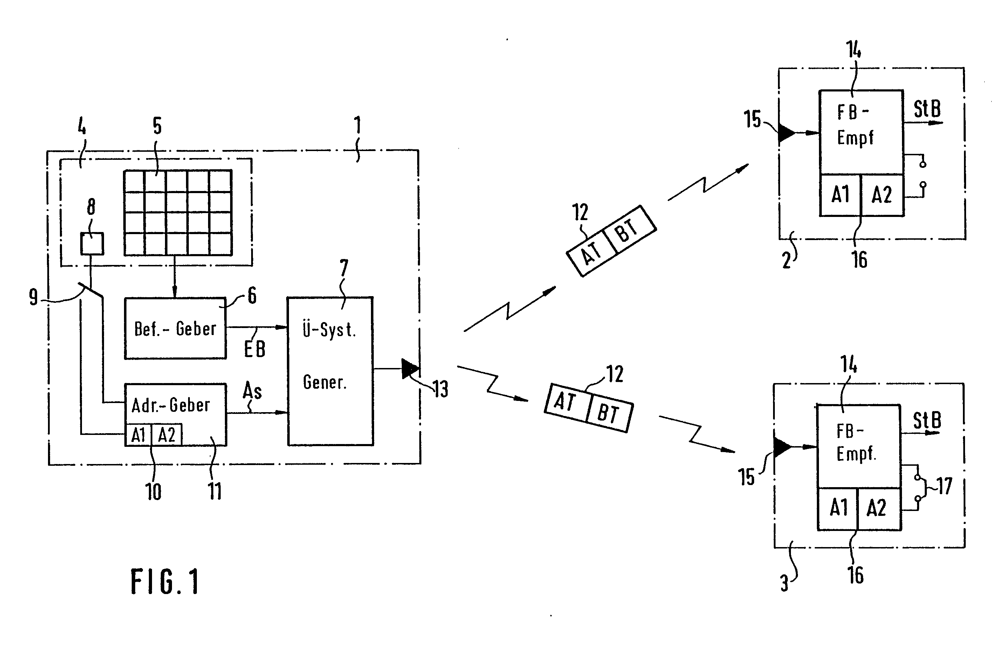

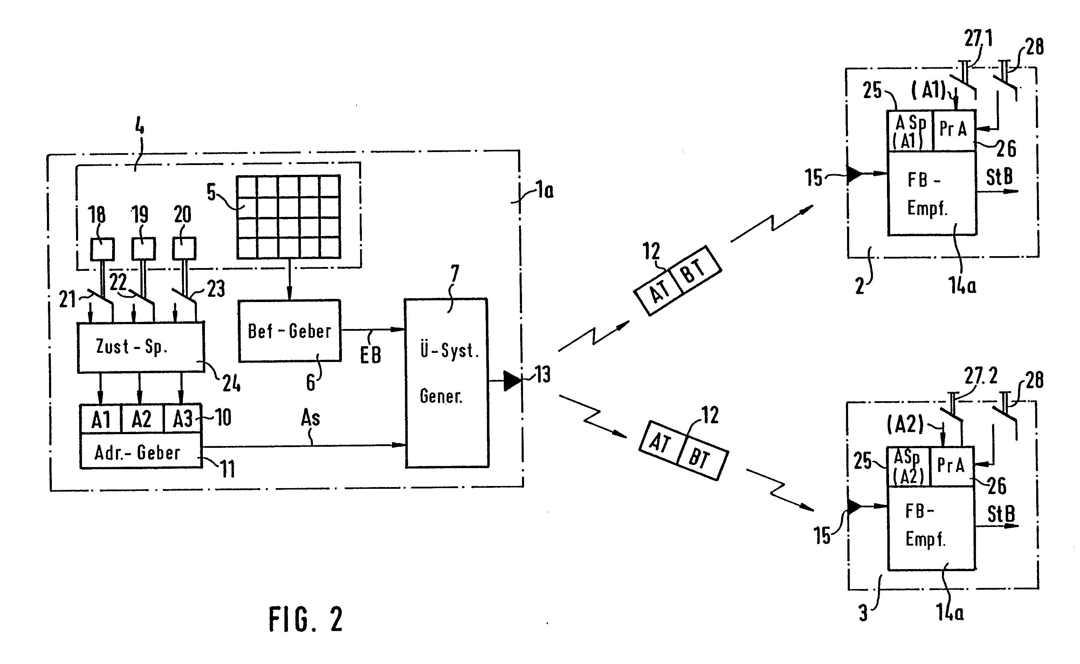

Die Erfindung wird nachfolgend anhand vorteilhafter Ausführungsbeispiele näher erläutert. In den Figuren 1 und 2 der zugehörigen Zeichnungen sind zwei Fernbedienungsanordnungen als Ausführungsbeispiele der Erfindung je in einem Blockschaltbild schematisch dargestellt.

Die in Fig. 1 schematisch durch die Schaltungsblöcke 1, 2 und 3 dargestellte Gerätegruppe besteht aus einem Fernbedienungsgeber 1 und aus zwei fernbedienbaren elektrischen Geräten 2 und 3. Der Fernbedienungsgeber 1 enthält ein Bedienungsfeld 4 mit einer Gruppe von tastenförmigen Bedienungselementen 5, an denen ein Benutzer von ihm ausgewählte Einstellungen für die fernbedienbaren elektrischen Geräte 2 oder 3 eingibt. Diese Eingaben wandelt ein Befehlsgeber 6 in Eingabebefehle EB um und überträgt diese Signale an einen Übertragungssignalgenerator 7 des Fernbedienungsgebers 1. Außerdem enthält das Bedienungsfeld 4 eine Taste 8, die zur Auswahl des fernzubedienenden elektrischen Gerätes dient. Diese Taste 8 stellt einen Schalter 9, der einen Adressenspeicher 10 in einem Adressengeber 11 des Fernbedienungsgebers steuert. Im offenen Zustand des Schalters 9 ist eine erste Adresse A1 wirksam, im geschlossenen Zustand des Schalters 9 ist eine zweite Adresse A2 des Adressenspeichers 10 wirksam. Beim Empfang eines Eingabebefehles EB ruft der Übertragungssignalgenerator 7 vom Adressengeber 11 ein Adressensignal AS ab, das die wirksame Adresse A1 des Adressenspeichers 10 enthält, und bildet daraus ein Fernbedienungssignal 12, das aus einem Adressenteil AT und einem Befehlsteil BT gebildet ist und von einem Senderelement 13 drahtlos an die fernbedienbaren elektrischen Geräte 2 und 3 übertragen wird.

Jedes der fernbedienbaren elektrischen Geräte 2 oder 3 enthält einen Fernbedienungsempfänger 14 mit einem Empfangselement 15, das die drahtlos übertragenen Fernbedienungssignale 12 empfängt und dem Fernbedienungsempfänger 14 zuführt. Der Fernbedienungsempfänger 14 enthält ebenfalls einen Adressenspeicher 16 mit den gleichen Adressen A1 und A2 wie der Adressenspeicher 10 des Adressengebers 11 des Fernbedienungsgebers 1. Die zweite Adresse A2 des Adressenspeichers 16 des Fernbedienungsempfängers 14 kann durch eine Löt- oder Schaltbrücke 17 wirksam geschaltet werden. Ohne diese Schaltbrücke ist die erste Adresse A1 des Adressenspeichers 16 wirksam. In dem in Fig. 1 dargestellten Ausführungsbeispiel ist im ersten fernbedienbaren elektrischen Gerät 2 die erste Adresse A1 wirksam und im zweiten fernbedienbaren elektrischen Gerät 3 die zweite Adresse A2 wirksam. Die Fernbedienungsempfänger 14 werten nur die empfangenen Fernbedienungssignale 12 aus, deren Adressenteil AT die Adresse (A1, A2) enthält, die im Adressenspeicher 16 des Fernbedienungsempfänger 14 wirksam geschaltet ist. Dadurch wertet der Fernbedienungsempfänger 14 des ersten fernbedienbaren elektrischen Gerätes 2 nur Fernbedienungssignale 12 aus, deren Adressenteil AT die erste Adresse A1 enthalten, und bildet aus dem Befehlsteil BT dieser Fernbedienungssignale 12 die zugehörigen Befehle StB zur Einstellung des ersten fernbedienbaren elektrischen Gerätes 2.

In Fig. 2 ist eine weitere Gerätegruppe mit zwei fernbedienbaren elektrischen Geräten 2 und 3 und einem gemeinsamen Fernbedienungsgeber 18 schematisch durch die Schaltungsbblöcke 2, 3 und 18 dargestellt. Sich entsprechende Schaltungsblöcke sind in den Figuren 1 und 2 durch gleiche Bezugzeichen gekennzeichnet. Der Fernbedienungsgeber 1a der in Fig. 2 dargestellten Gerätegruppe unterscheidet sich von dem in Fig. 1 dargestellten Fernbedienungsgebers 1 im wesentlichen dadurch, daß das Bedienungsfeld für jedes vom Fernbedienungsgeber aus anwählbare und fernbedienbare elektrische Gerät 2, 3, eine Auswahltaste 18, 19, 20, von den Auswahltasten betätigbare Schalter 21, 22 und 23 und einen Tastenspeicher 24 enthält, der die Betätigung der zuletzt betätigten Auswahltaste (z.B. 21) speichert und die dem zuletzt betätigten Schalter zugeordnete Adresse (z.B. A1) des Adressenspeichers 10 im Adressengeber 11 so lange wirksam schaltet, bis ein anderer Schalter 22 oder 23 betätigt wird. Vor einer Fernbedienung der fernbedienbaren elektrischen Geräte 2 oder 3 mittels der Einstellelemente 5 des Bedienungsfeldes 4 des Fernbedienungsgebers 1a muß zuerst durch Betätigen einer der Auswahltasten 18, 19 oder 20 das fernbedienbare elektrische Gerät 2 oder 3 ausgewählt werden, das fernbedient werden soll. Ist diese Auswahl getroffen, werden in dem Übertragungssignalgenerator 7 alle nachfolgenden Einstellbefehle mit der ausgewählten Adresse (z.B. A1) zum Fernbedienungssignal 12 vervollständigt.

Die Fernbedienungsempfänger 14a der fernbedienbaren elektrischen Geräte 2 und 3 enthalten einen Adressenspeicher 25, der im unprogrammierten Zustand keine Adresse enthält. In diesen Adressenspeicher 25 wird die den Fernbedienungsempfänger kennzeichnende Adresse A1 oder A2 durch einen am Fernbedienungsempfänger 14a ausgelösten, im Fernbedienungsempfänger enthaltenen Programmablauf 26, während dem die den Fernbedienungsempfänger 14a kennzeichnende Adresse A1 oder A2 oder A3 eingegeben wird, in den Adressenspeicher 25 eingespeichert. Die in den Adressenspeicher 25 eines Fernbedienungsempfängers 14a eingespeicherten Adressen A1 oder A2 oder A3 müssen natürlich mit einer der in dem Adressenspeicher 10 eingespeicherten Adressen des Adressengebers 11 des Fernbedienungsgebers 1a übereinstimmen. Die Auslösung des Programmablaufes 26 im Fernbedienungsempfänger 14a und die Eingabe der den Fernbedienungsempfänger kennzeichnenden Adresse kann beispielsweise mittels schon vorhandener Bedienungselemente 27 und 28 der Ortsbedienung der fernbedienbaren elektrischen Geräte 2 und 3 eingegeben werden, so daß hierzu keine zusätzlichen Einstellelemente an den fernbedienbaren elektrischen Geräten erforderlich sind und das Auslösen des Programmablaufes 26 lediglich durch die Betätigung einer bestimmten Kombination dieser Bedienungselemente 27, 28 ausgelöst wird.

### Ansprüche

1. Fernbedienungsanordnung zur Fernbedienung einer Gruppe fernbedienbarer elektrischer Geräte mittels eines Fernbedienungsgebers, der beim Auslösen eines Stellbefehles ein Fernbedienungssignal erzeugt und drahtlos an einen Fernbedienungsempfänger eines der elektrischen Geräte überträgt,

**dadurch gekennzeichnet,**

- daß jedes elektrische Gerät (2, 3) der Gruppe einen Fernbedienungsempfänger (14, 14a) zum Empfang der drahtlos übertragenen Fernbedienungssignale (12) enthält,

- daß jeder Fernbedienungsempfänger eine Vorrichtung (17, 26) zum Einstellen einer den Fernbedienungsempfänger kennzeichnenden Adresse (A1, A2) enthält und nur die Fernbedienungssignale auswertet, die als Signalbestandteil (AT) die am Fernbedienungsempfänger eingestellte Adresse enthalten,

- und daß der Fernbedienungsgeber (1, 1a). eine Einstelleinrichtung (8, 18, 19, 20) zur Auswahl des einzustellenden elektrischen Gerätes enthält, mit deren Einstellung an einem im Fernbedienungsgeber enthaltenen Adressensignalgeber (11) die Ausgabe des dem ausgewählten elektrischen Gerät zugeordneten Adressensignals (AS) ausgelöst wird.

2. Fernbedienungsanordnung nach Anspruch 1, dadurch gekennzeichnet, daß im Adressensignalgeber (11) des Fernbedienungsgebers (1) und in den Fernbedienungsempfängern (14) einer Gerätegruppe je ein gleicher Satz auswählbarer Adressen (A1, A2) eingespeichert ist.

3. Fernbedienungsgeber einer Fernbedienungsanordnung nach Anspruch 1 oder 2, dadurch gekennzeichnet, daß die Einstellanordnung zur Auswahl eines Adressensignals (AS) des Adressensignalgebers (11) ein Tastschalter (9) ist, dessen Einstelltaste (8) auf dem Bedienungsfeld (4) des Fernbedienungsgebers (1) angeordnet ist.

4. Fernbedienungsgeber einer Fernbedienungsanordnung nach Anspruch 1 oder 2, dadurch gekennzeichnet, daß die Einstellanordnung zur Auswahl eines Adressensignals (AS) des Adressensignalgebers (11) ein mehrere Tastschalter (21, 22, 23) enthaltender Betätigungsspeicher (24) ist, der jeweils für den zuletzt betägten Tastschalter (21) ein Auswahlsignal zur Auswahl des zugehörigen Adressensignals (AS) erzeugt.

FIG.1

FIG. 2